(19) Europäisches Patentamt European Patent Office Office européen des brevets

(11) **EP 3 488 027 B1**

(12) **EUROPEAN PATENT SPECIFICATION**

(45) Date of publication and mention of the grant of the patent:
**19.08.2020 Bulletin 2020/34**

(21) Application number: **17749388.9**

(22) Date of filing: **20.07.2017**

(51) Int Cl.:
*C25B 1/00* (2006.01)    *H01L 31/068* (2012.01)
*H01L 31/0236* (2006.01)    *H01L 31/18* (2006.01)

(86) International application number:
**PCT/EP2017/068423**

(87) International publication number:
**WO 2018/015514 (25.01.2018 Gazette 2018/04)**

(54) **PHOTOELECTROCHEMICAL WATER SPLITTING DEVICE FOR SOLAR HYDROGEN GENERATION AND METHOD FOR FABRICATING THE SAME**

PHOTOELEKTROCHEMISCHE WASSERSPALTUNGSVORRICHTUNG FÜR SOLARE WASSERSTOFFERZEUGUNG UND VERFAHREN UM DIESE ANZUFERTIGEN

DISPOSITIF DE CRAQUAGE DE L'EAU PHOTOÉLECTROCHIMIQUE POUR LA GENERATION D'HYDROGÈNE ET METHODE DE FABRICATION DE CELUI-CI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.07.2016 IT 201600076708**

(43) Date of publication of application:
**29.05.2019 Bulletin 2019/22**

(73) Proprietor: **Università degli Studi di Milano - Bicocca 20126 Milano (IT)**

(72) Inventors:
• **NOETZEL, Richard 5612 HX Eindhoven (NL)**
• **SANGUINETTI, Stefano 20081 Abbiategrasso (IT)**

(74) Representative: **Palladino, Saverio Massimo et al Notarbartolo & Gervasi S.p.A. Viale Achille Papa, 30 20149 Milano (IT)**

(56) References cited:
**US-A1- 2011 005 590**

• **PAUL E.D. SOTO RODRIGUEZ ET AL: "Electrocatalytic oxidation enhancement at the surface of InGaN films and nanostructures grown directly on Si(111)", ELECTROCHEMISTRY COMMUNICATIONS, vol. 60, 9 September 2015 (2015-09-09), pages 158-162, XP055286402, NL ISSN: 1388-2481, DOI: 10.1016/j.elecom.2015.09.003**
• **NAVEED UL HASSAN ALVI ET AL: "InN/InGaN quantum dot photoelectrode: Efficient hydrogen generation by water splitting at zero voltage", NANO ENERGY, vol. 13, 6 March 2015 (2015-03-06), pages 291-297, XP055337961, ISSN: 2211-2855, DOI: 10.1016/j.nanoen.2015.02.017 cited in the application**
• **WEI GUO ET AL: "Catalyst-Free InGaN/GaN Nanowire Light Emitting Diodes Grown on (001) Silicon by Molecular Beam Epitaxy", NANO LETTERS, vol. 10, no. 9, 8 September 2010 (2010-09-08), pages 3355-3359, XP055337977, US ISSN: 1530-6984, DOI: 10.1021/nl101027x**

## Description

## FIELD OF INVENTION

The invention relates to the field of renewable energy in general, and specifically to the generation of hydrogen by water splitting driven by solar energy.

## BACKGROUND AND PRIOR ART

Some traditional energy sources, which have accounted for the great part of the energy produced and consumed globally so far, pose nowadays problems. In particular, regarding petroleum, one first problem is its shortage in the next future; more in general, fossil fuels (petroleum and its derivatives, coal, and similar products) are responsible for the greenhouse effect, the climate change - global warming and its consequences; finally, nuclear fuels and plants are intrinsically dangerous, and the end-products of generation of nuclear energy pose serious problems of safe storing for extremely long periods (even thousands of years or more) for which a viable solution has not yet been found.

In view of these problems, in the last few decades many research efforts have been directed towards the identification of new energy sources, which desirably should be renewable (i.e., not subject to exhausting like fossil fuels) and such that their use does not present dangerous side-effects.

A promising candidate is solar energy.

A possibility of recovery of solar energy is through the direct conversion of solar light into electrical energy by means of photovoltaic cells. A problem in this case is, however, the storage of energy to cope with the varying energy harvesting (day, night, weather) and the varying needed supply.

Another approach, is the use of solar energy to split water into hydrogen and oxygen; the hydrogen so produced can be stored and used when needed to produce energy through recombination with oxygen, either by direct combustion or in fuel cells. This approach offers the advantage that storing of hydrogen is easier than that of electricity; and the recombination of hydrogen and oxygen gives rise to water and is thus completely safe and environmentally friendly.

Currently, the two main routes pursued for solar hydrogen generation are based on (i) wide-bandgap metal oxides or III-V semiconductors used as photoelectrodes for direct photoelectrochemical water splitting; and (ii) photovoltaic cells for catalyst-assisted water electrolysis.

Electrodes for direct photoelectrochemical water splitting currently have, however, low efficiencies of less than 2%; besides, they need an external voltage supply to drive the water splitting reaction, thus reducing the net energy balance and the utility of the system.

To date, the highest solar to hydrogen efficiencies of about 10% have been achieved with water electrolysis driven by photovoltaic cells. Examples of this kind of systems are reported in patent US 6,936,143 B1 and in patent application WO 2011/006102 A2 (in these documents, the system is defined "tandem cell"). The required multi-junction cells or modules are, however, sophisticated to manufacture and costly, which also applies to the needed electrocatalyst systems. Moreover, to be practically useful, a solar system for hydrogen generation should have a power conversion efficiency of no less than 15%, and preferably of about 20% or higher: the systems proposed in cited documents have not shown these levels of efficiency; the power conversion efficiency is measured with the following formula:

$$\eta = \frac{j \times 1.23\ V}{P}$$

in which:

$\eta$ is the solar to hydrogen power conversion efficiency;
$j$ is the photo-current density in mA/cm$^2$;
1.23 V is the theoretically minimum voltage needed to split water; and
P is the incident light power density in mW/cm$^2$.

A novel photoanode has been disclosed recently in the paper "InN/InGaN quantum dot photoelectrode: Efficient hydrogen generation by water splitting at zero voltage", N. H. Alvi et al., Nano Energy (2015) 13, 291-297. This photoanode exploits the activity of InN quantum dots produced over an InGaN surface, that drives direct photoelectrochemical hydrogen generation by water splitting at zero externally applied voltage with a solar to hydrogen efficiency of 6%; the efficiency increases to 20% at 0.4 V external bias. Such photoanodes have an ohmic contact with p-Si and can therefore be integrated with Si photovoltaic cells, easily providing the bias of 0.4 V without limiting the current in order to reach the 20% efficiency.

To achieve these levels of efficiency, the quantum dots of InN must be grown over the c-surface of the InGaN layer; in turn, this requires direct growth on Si exposing the crystallographic (111) surface. However, most common, commercial Si photovoltaic cells are n-type up and fabricated on p-type Si substrates exposing the (100) surface. The problem is, therefore, the wrong surface orientations and doping sequence for producing this hybrid water splitting device integrating the InN-InGaN quantum dot photoanode with a commercial Si photovoltaic cell.

PAUL E.D. SOTO RODRIGUEZ ET AL: "Electrocatalytic oxidation enhancement at the surface of InGaN films and nanostructures grown directly on Si(111)", ELECTROCHEMISTRY COMMUNICATIONS, vol. 60, 9 September 2015 (2015-09-09), pages 158-162, discloses an electrode consisting of a Si (111) substrate onto which an InGaN layer decorated with InN quantum dots is epitaxially grown, and its possible application as a photoelectrode for water splitting.

US 2011/005590 A1 discloses a photovoltaic/photoelectrochemical tandem for water splitting, comprising a Si-solar cell with an InAlGaN or InGaN photoanode.

Besides, the inventors have observed that the photoanodes object of previous studies are prone to oxidation leading to rapid degradation of the water splitting properties of the system.

It is an object of the present invention to provide a photoanode that does not undergo rapid degradation of water splitting efficiency, and a method for producing said photoanode on conventional Si photovoltaic cells while retaining the high activity required for the intended application.

## SUMMARY OF THE INVENTION

This and other objects are achieved with the present invention, which in a first aspect thereof relates to a novel hybrid device integrating a photoanode produced on a commercial Si photovoltaic cell, characterized in that the photoanode is made of a InGaN layer epitaxially grown over (111) crystallographic planes of p-type silicon, and in that quantum dots of InN are produced over the exposed surface of the InGaN layer, said quantum dots having a ratio of height/diameter lower than 0.25.

In a second aspect thereof, the invention relates to process for the production of the improved hybrid cell object of the first aspect.

## BRIEF DESCRIPTION OF THE DRAWINGS

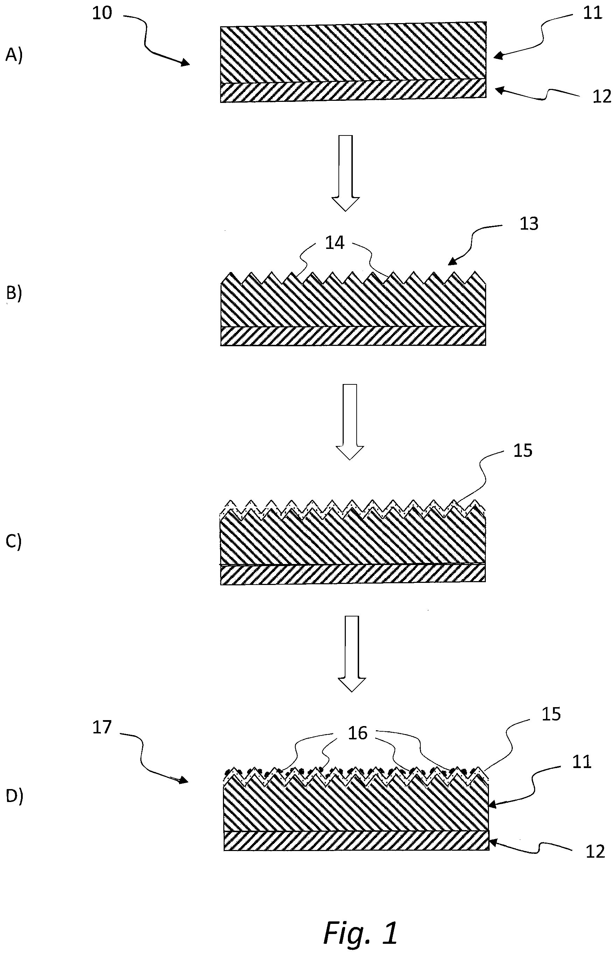

The invention will be described in detail in the following with reference to Figure 1, which shows the different stages of production of a hybrid device of the invention.

In the drawings, the size of the different parts is not in scale, and in particular the thickness of the film of InGaN and the size of the quantum dots of InN present over said film are greatly exaggerated for clarity of representation.

## DETAILED DESCRIPTION OF THE INVENTION

In its first aspect, the invention refers to a hybrid device, monolithically integrating a photoanode with a silicon photovoltaic cell.

The photoanode is a film of InGaN formed on the photovoltaic cell, with quantum dots of InN formed on the surface of said film; in particular, the InGaN film is in contact with the positively doped silicon (p-type Si) face of the photovoltaic cell.

The InGaN film is continuous on the silicon surface, and has a thickness ranging between 10 and 100 nm, preferably between 50 and 60 nm.

The InN quantum dots (also abbreviated QDs in the following), on the other hand, are discontinuous structures produced over the InGaN surface. These QDs have a thickness below 5 nm, preferably between 3 and 4 nm, and a diameter between 20 and 30 nm; as generally the QDs are not perfectly circular, by "diameter" it is meant the length of the major axis of the dots.

The inventors have found that, for the aims of the present invention, the quantum dots must expose the crystallographic c-plane of the InN crystal; this condition is achieved by growing the QDs onto an InGaN film that in its turn exposes the corresponding c-plane of its crystalline structure.

Following their studies, the inventors have ascertained that the c-plane InN QDs surface contains a high density of intrinsic positively charged surface donors. These surface donors have transferred an electron to the semiconductor forming an electron surface accumulation layer therein. Hence oxidation of the surface, i.e., giving away more electrons is not possible, making the surface resistant against corrosion. As the c-plane has the largest density of positively charged surface donors it is the plane most resistant against corrosion. The condition set for the QDs in the present invention, namely, that these dots must have a ratio height/diameter of 0.25 or less, maximizes the c-plane exposed surfaces, making it possible to achieve a hybrid device with improved corrosion resistance compared to the cells of the prior art.

As the InGaN film is built on the silicon surface and has a very low thickness, it will reproduce the crystalline structure of the surface of the substrate it is built upon (epitaxial growth). Given the crystallographic structures of InGaN and Si, a growth of said film perpendicular to its c-axis (and thus exposing as surface the c-plane) requires that the underlying silicon surface is a (111) plane of the silicon crystal.

In a second aspect thereof, the invention is about a method for producing the hybrid device described above.

As said, the hybrid device is produced by treating a commercial silicon photovoltaic cell to change the crystallographic orientation of the exposed surface, first growing the InGaN layer over the so-treated silicon photovoltaic cell, and finally producing the InN QDs over said layer. The description of the procedure is made with reference to Fig. 1.

Fig. 1.A schematically shows a standard silicon photovoltaic cell (10). Said standard cell generally comprises a double layer of silicon, one (11) positively doped (p-type Si) and the other (12) negatively doped (n-type Si). For ease of production, both layers have their main (exposed) surface corresponding to the (100) crystallographic planes of the silicon crystal. However, as said, for the aims of the present invention the InGaN film must be grown over (111) surfaces of the silicon substrate, and in particular over the p-type side of the photovoltaic cell.

Accordingly, the first step of the process of the invention is the processing of the surface of a commercial silicon PV cell, exposing (100) planes of the silicon crystal structure, to transform said surface into one that exposes facets corresponding to (111) planes of the silicon crystal structure.

To obtain the necessary condition, the p-type (100) surface of the photovoltaic cell may be chemically etched in order to obtain a textured surface exposing silicon (111) planes. The result is represented in Fig. 1.B, in which is shown the textured surface, 13, made of a plurality of (111) facets 14. The etching must be anisotropic, namely, the etching rate must be different along the different crystallographic axes of the silicon crystal. This anisotropic etching can be obtained, for instance, with aqueous solutions of alkali metal hydroxides or ammonium hydroxide, optionally containing a monohydric, dihydric or polyhydric alcohol; a useful etching solution is an aqueous solution of potassium hydroxide (KOH), at concentration of about 45% by weight (weight of hydroxide/weight of resulting solution). The result is a new exposed surface, made of a plurality of pyramids whose facets correspond to (111) planes of the Si crystal. By chemical etching, the size and pitch of the pyramids is controlled by the etching conditions (alkali concentration and temperature).

Alternatively, the necessary texturing of the silicon surface can be achieved by means of lithographic approaches, allowing to obtain ordered structures and other arrangements like ridges, inverted pyramid arrays, and networks.

Following any of these techniques, the silicon surface will be formed of a series of (111) silicon facets.

Prior to texturing, the p-type side of the cell can be optionally (and preferably) thinned to enhance the transmission of light through it; in fact, in operation, light impinges on the substrate back side (p-type surface). Thinning may be done by mechanical grinding.

Once the silicon substrate is textured to expose (111) facets, the InGaN layer (15) is produced over textured surface 13 (Fig. 1.C). Preferred epitaxial growth techniques are molecular beam epitaxy and metalorganic vapor phase epitaxy. Finally, as shown in Fig. 1.D, the InN QDs, 16 are grown over the InGaN layer, obtaining the hybrid device of the invention, 17.

The methods and procedures for growing the InGaN layer and the InN QDs of desired thickness and size are known to the skilled persons; a possible example of growth of InN-InGaN quantum dots on Si (111) is described in the reference P.E.D. Soto Rodriguez et al., "Stranski-Krastanov InN/InGaN Quantum Dots Grown directly on Si(111)", Applied Physics Letters 106, 023105 (2015), in the last paragraph starting on page 1 and continued on page 2.

## Claims

1. Hybrid device (17) monolithically integrating a photoanode and a commercial Si photovoltaic cell (10), the commercial silicon photovoltaic cell comprising a layer of positively doped silicon (p-type Si) and a layer of negatively doped silicon (n-type Si), **characterized in that** the photoanode is made of a InGaN layer (15) epitaxially grown over (111) crystallographic planes of the p-type silicon, and **in that** quantum dots of InN (16) are produced over the exposed surface of the InGaN layer, said quantum dots having a ratio of height/diameter lower than 0.25.

2. Hybrid device according to claim 1, wherein said InGaN film is continuous on the silicon surface, and has a thickness between 10 and 100 nm.

3. Hybrid device according to claim 2, wherein said InGaN film has a thickness between 50 and 60 nm.

4. Hybrid device according to any one of claims 1 to 3, wherein said InN quantum dots have a thickness below 5 nm and a diameter between 20 and 30 nm.

5. Hybrid device according to claim 4, wherein said InN quantum dots have a thickness between 3 and 4 nm.

6. Method for producing a hybrid device (17) according to any one of claims 1 to 5, comprising the steps of:

   - providing a commercial silicon photovoltaic cell (10) comprising a layer (11) of positively doped silicon (p-type Si) and a layer (12) of negatively doped silicon (n-type Si), in which both layers have their main exposed surface corresponding to the (100) crystallographic planes of the silicon crystal;
   - processing the surface of the p-type layer (11) of said silicon photovoltaic cell to change said surface into a textured surface (13) that exposes facets (14) corresponding to (111) planes of the silicon crystal structure;
   - epitaxially producing a InGaN layer (15) over said textured surface (13);
   - epitaxially producing InN quantum dots (16) over said InGaN layer (15).

7. Method according to claim 6 wherein, before carrying out the step of processing for obtaining said textured surface (13), the p-type layer (11) of the silicon photovoltaic cell is thinned.

8. Method according to claim 7 wherein said thinning is done by mechanical grinding.

9. Method according to any one of claims 6 to 8, wherein the step of processing the surface of the p-type layer (11) for obtaining said textured surface (13) is carried out by anisotropic chemical etching or physical etching.

10. Method according to claim 9, wherein said anisotropic chemical etching is carried out with an aqueous solution of one or more alkali metal hydroxides, ammonium hydroxide, or mixtures thereof, optionally containing a monohydric, dihydric or polyhydric alcohol.

11. Method according to claim 10, wherein said etching solution is an aqueous solution of potassium hydroxide (KOH), at concentration of about 45% by weight.

12. Method according to any one of claims 6 to 11, wherein said InGaN layer (15) and said InN quantum dots (16) are produced by molecular beam epitaxy or metalorganic vapor phase epitaxy.

**Patentansprüche**

1. Hybridvorrichtung (17), die monolithisch eine Photoanode und eine im Handel erhältliche Si-Solarzelle (10) integriert, wobei die im Handel erhältliche Si-Solarzelle eine Schicht aus positiv dotiertem Silizium (p-Typ-Si) und eine Schicht aus negativ dotiertem Silizium (n-Typ-Si) umfasst, **dadurch gekennzeichnet, dass** die Photoanode aus einer InGaN-Schicht (15) hergestellt ist, die epitaktisch über (111) kristallografischen Ebenen des p-Typ-Siliziums gewachsen ist, und dadurch, dass Quantenpunkte aus InN (16) über der freiliegenden Fläche der InGaN-Schicht hergestellt sind, wobei die Quantenpunkte ein Verhältnis von Höhe/Durchmesser von kleiner als 0,25 aufweisen.

2. Hybridvorrichtung nach Anspruch 1, wobei der InGaN-Film auf der Siliziumfläche ununterbrochen ist und eine Dicke von zwischen 10 und 100 nm aufweist.

3. Hybridvorrichtung nach Anspruch 2, wobei der InGaN-Film eine Dicke von zwischen 50 und 60 nm aufweist.

4. Hybridvorrichtung nach einem der Ansprüche 1 bis 3, wobei die InN-Quantenpunkte eine Dicke von unter 5 nm und einen Durchmesser von zwischen 20 und 30 nm aufweisen.

5. Hybridvorrichtung nach Anspruch 4, wobei die InN-Quantenpunkte eine Dicke von zwischen 3 und 4 nm aufweisen.

6. Verfahren zur Herstellung einer Hybridvorrichtung (17) nach einem der Ansprüche 1 bis 5, das die folgenden Schritte umfasst:

- Bereitstellen einer im Handel erhältlichen Silizium-Solarzelle (10), die eine Schicht (11) aus positiv dotiertem Silizium (p-Typ-Si) und eine Schicht (12) aus negativ dotiertem Silizium (n-Typ-Si) umfasst, in der beide Schichten ihre freiliegende Hauptfläche den (100) kristallographischen Ebenen des Siliziumkristalls entsprechend aufweisen;
- Verarbeiten der Fläche der p-Typ-Schicht (11) der Silizium-Solarzelle zum Ändern der Fläche in eine strukturierte Fläche (13), die Facetten (14) freilegt, die Ebenen (111) der Siliziumkristallstruktur entsprechen;
- epitaktisches Herstellen einer InGaN-Schicht (15) über der strukturierten Fläche (13);
- epitaktisches Herstellen von InN-Quantenpunkten (16) über der InGaN-Schicht (15).

7. Verfahren nach Anspruch 6, wobei vor dem Durchführen des Schritts der Verarbeitung zum Erhalten der strukturierten Oberfläche (13) die p-Typ-Schicht (11) der Silizium-Solarzelle verdünnt wird.

8. Verfahren nach Anspruch 7, wobei das Verdünnen durch mechanisches Schleifen erfolgt.

9. Verfahren nach einem der Ansprüche 6 bis 8, wobei der Schritt der Verarbeitung der Fläche der p-Typ-Schicht (11) zum Erhalten der strukturierten Fläche (13) durch anisotropes chemisches Ätzen oder physikalisches Ätzen durchgeführt wird.

10. Verfahren nach Anspruch 9, wobei das anisotrope chemische Ätzen mit einer wässrigen Lösung aus einem oder mehreren Alkalimetall-Hydroxiden, Ammoniumhydroxid oder Mischungen davon durchgeführt wird, wobei diese wahlweise einen einwertigen, zweiwertigen oder mehrwertigen Alkohol enthält.

11. Verfahren nach Anspruch 10, wobei die Ätzlösung eine wässrige Lösung von Kaliumhydroxid (KOH) mit einer Konzentration von etwa 45 Gew.-% ist.

12. Verfahren nach einem der Ansprüche 6 bis 11, wobei die InGaN-Schicht (15) und die InN-Quantenpunkte (16) durch Molekularstrahl-Epitaxie oder metallorganische Gasphasenepitaxie hergestellt werden.

**Revendications**

1. Dispositif hybride (17) intégrant monolithiquement une photo-anode et une pile photovoltaïque au Si commerciale (10), la cellule photovoltaïque au silicium commerciale comprenant une couche de silicium dopé positivement (Si de type p) et une couche de silicium dopé négativement (Si de type n), **caractérisé en ce que** la photo-anode est constituée d'une couche d'InGaN (15) réalisée par croissance épitaxiale sur (111) des plans cristallographiques du silicium de type p, et **en ce que** des points quantiques d'InN (16) sont produits sur la surface exposée de la couche d'InGaN, lesdits points quantiques ayant un rapport hauteur/diamètre inférieur à 0,25.

2. Dispositif hybride selon la revendication 1, dans lequel ledit film d'InGaN est continu sur la surface de silicium, et a une épaisseur entre 10 et 100 nm.

3. Dispositif hybride selon la revendication 2, dans lequel ledit film d'InGaN a une épaisseur entre 50 et 60 nm.

4. Dispositif hybride selon l'une quelconque des revendications 1 à 3, dans lequel lesdits points quantiques d'InN ont une épaisseur inférieure à 5 nm et un diamètre entre 20 et 30 nm.

5. Dispositif hybride selon la revendication 4, dans lequel lesdits points quantiques d'InN ont une épaisseur entre 3 et 4 nm.

6. Procédé pour produire un dispositif hybride (17) selon l'une quelconque des revendications 1 à 5, comprenant les étapes suivantes :

   - la fourniture d'une cellule photovoltaïque au silicium commerciale (10) comprenant une couche (11) de silicium dopé positivement (Si de type p) et une couche (12) de silicium dopé négativement (Si de type n), dans lequel les deux couches ont leur surface exposée principale correspondant aux (100) plans cristallographiques du cristal de silicium ;
   - le traitement de la surface de la couche de type p (11) de ladite cellule photovoltaïque au silicium pour changer ladite surface en une surface texturée (13) qui expose des facettes (14) correspondant à (111) des planes de la structure cristalline de silicium ;
   - la production épitaxiale d'une couche d'InGaN (15) sur ladite structure texturée (13);
   - la production épitaxiale de points quantiques d'InN (16) sur ladite couche d'InGaN (15).

7. Procédé selon la revendication 6 dans lequel, avant l'exécution de l'étape de traitement pour obtenir ladite surface texturée (13), la couche de type p (11) de la cellule photovoltaïque au silicium est amincie.

8. Procédé selon la revendication 7 dans lequel ledit amincissement est effectué par meulage mécanique.

9. Procédé selon l'une quelconque des revendications 6 à 8, dans lequel l'étape de traitement de la surface de la couche de type p (11) pour obtenir ladite surface texturée (13) est exécutée par gravure chimique anisotrope ou gravure physique.

10. Procédé selon la revendication 9, dans lequel ladite gravure chimique anisotrope est exécutée avec une solution aqueuse d'un ou plusieurs hydroxydes de métal alcalin, hydroxyde d'ammonium ou des mélanges de ceux-ci, éventuellement contenant un alcool monohydrique, dihydrique ou polyhydrique.

11. Procédé selon la revendication 10, dans lequel ladite solution de gravure est une solution aqueuse d'hydroxyde de potassium (KOH), à une concentration d'environ 45% en poids.

12. Procédé selon l'une quelconque des revendications 6 à 11, dans lequel ladite couche d'InGaN (15) et lesdits points quantiques d'InN (16) sont produits par épitaxie par faisceau moléculaire ou épitaxie organométallique en phase vapeur.

A)

10

11

12

B)

13

14

C)

15

D)

17

16

15

11

12

*Fig. 1*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6936143 B1
- WO 2011006102 A2
- US 2011005590 A1

**Non-patent literature cited in the description**

- **N. H. ALVI et al.** InN/InGaN quantum dot photoelectrode: Efficient hydrogen generation by water splitting at zero voltage. *Nano Energy,* 2015, vol. 13, 291-297
- **PAUL E.D. SOTO RODRIGUEZ et al.** Electrocatalytic oxidation enhancement at the surface of InGaN films and nanostructures grown directly on Si(111). *ELECTROCHEMISTRY COMMUNICATIONS,* 09 September 2015, vol. 60, 158-162
- **SOTO RODRIGUEZ et al.** Stranski-Krastanov InN/InGaN Quantum Dots Grown directly on Si(111). *Applied Physics Letters,* 2015, vol. 106, 023105